# EUROPEAN PATENT APPLICATION

(11) **EP 2 843 699 A1**
(43) Date of publication of application: **04.03.2015**
(21) Application number: 13197984.1
(22) Date of filing: 18.12.2013
(51) Int. Cl.: H01L 23/367, F28F 3/06

(54) **Assembled aluminum extrusion heat dissipator**

(30) Priority: 29.08.2013 TW 102130973
(71) Applicant: Delta Electronics, Inc., Taoyuan County 32063 (TW)
(72) Inventor: Lee, Lei-Ming, 32063 Chungli Industrial Zone, Taoyuan County (TW); Yeh, Chia-Hao, 32063, Chungli Industrial Zone, Taoyuan County (TW)
(74) Representative: 2K Patentanwälte Blasberg Kewitz & Reichel

(57) **Abstract**

An assembled aluminum extrusion heat dissipator (1, 1a) includes a heat-conducting plate (10, 10a) and a plurality of U-shaped heat-dissipating members (20, 20', 20a, 20a'). The surface (101) of the heat-conducting plate (10, 10a) has a plurality of slots (11, 11a), and each of the slots (11, 11a) extends from one side of the heat-conducting plate (10, 10a) to another corresponding side. The U-shaped heat-dissipating member (20, 20', 20a, 20a') has a U-shaped body (21) and a plurality of heat-dissipating fins (22), and the U-shaped body (21) having a bottom plate (211) and a pair of lateral plates (212), wherein the distance between the pair of lateral plates (212) is corresponding to the distance of the two adjacent slots (11, 11a), so that the pair of lateral plates (212) insert into the two adjacent slots (11, 11a), and the U-shaped heat-dissipating member (20, 20', 20a, 20a') integrates with the heat-conducting plate (10, 10a).

## Description

### BACKGROUND OF THE INVENTION

### FIELD OF THE INVENTION

The present invention generally relates to an aluminum extrusion heat dissipator, more particularly to an assembled aluminum extrusion heat dissipator.

### DESCRIPTION OF THE RELATED ART

Nowadays, electronic devices are equipped with heat dissipators, in order to lower temperatures. Since when temperature goes up, the electronic device may be abnormal or damaged.

For example, the structure of an aluminum extrusion heat dissipator adopts a plurality of fins that are parallelized and vertically extend from a heat-conducting plate of the aluminum extrusion heat dissipator. In practice, the heat-conducting plate is adhered to a heating component so as to dissipate heat via the fins with a totally large area.

Generally speaking, a heat dissipator dissipating heat from a heating electronic device adopts the two ways of forced convection flow and natural convection flow. The forced convection flow uses a fan to exclude heat, therefore the gap between the two fins of the fan can be smaller, and under a unit area, the amount of the fin may be more to promote the heat-dissipating effect. On the other hand, the natural convection flow may not use a fan, since if the gap is too small, the obstruction to air flow may be increased. That is to say, the heat-dissipating effect will be lowered down correspondingly. Hence the gap between two fins may have to be controlled in a certain distance.

In addition, to design the fins of a current aluminum extrusion heat dissipator shall develop a mold to fit the practical demands of lengths, widths, and gaps of a fin. If there are other products, other new developed molds or altered molds shall be proceeded. Accordingly, the time of development must be prolonged and cost will increase.

Therefore, the inventor spends time to research the issue, and finally proposes the present invention that figures out aforesaid shortcomings.

### SUMMARY OF THE INVENTION

The main objective of the present invention is to provide an assembled aluminum extrusion heat dissipator, so as to increase the flexible application of the heat dissipator, reduce the time of development, and save cost.

To approach above objective, an assembled aluminum extrusion heat dissipator of the present invention comprises a heat-conducting plate and at least one U-shaped heat-dissipating member. The surface of the heat-conducting plate has a plurality of slots that are parallel to each other, the slot is constructed by two boards that are spaced, the boards outwardly extend from the surface of the heat-conducting plate, and each of the slots extends from one side of the heat-conducting plate to another corresponding side. The U-shaped heat-dissipating member has a U-shaped body and a plurality of heat-dissipating fins. The U-shaped body has a bottom plate and a pair of lateral plates that bend and extend from the two opposite sides of the bottom plate, the heat-dissipating fins extend from the inner wall of one of the lateral plates to the other lateral plate. Wherein the distance between the pair of lateral plates is corresponding to the distance of the two adjacent slots, so that the pair of lateral plates insert into the two adjacent slots, and the U-shaped heat-dissipating member integrates with the heat-conducting plate.

The second objective of the present invention is to provide the assembled aluminum extrusion heat dissipator, wherein the plurality of the U-shaped heat-dissipating members in any of the two adjacent slots are serially or intermittently arranged, and the plurality of the U-shaped heat-dissipating members are different in height or length, in order to keep away from other components and increase the application flexibility. Compared to related arts, the assembled aluminum extrusion heat dissipator is to insert the U-shaped heat-dissipating members into the slots of the heat-conducting plate. Through plural arrangements of the U-shaped heat-dissipating members, different heat dissipators based on practical demands may be assembled. Besides, using the U-shaped heat-dissipating members with different heights or lengths, a height difference is formed in order to keep away from other components for more applications, wherein the U-shaped heat-dissipating members with different heights or lengths are produced by different molds.

### BRIEF DESCRIPTION OF THE DRAWINGS

The objects, spirits, and advantages of the preferred embodiments of the present invention will be readily understood by the accompanying drawings and detailed descriptions, wherein:
Fig. 1 illustrates a schematic perspective view of the assembled aluminum extrusion heat dissipator of the present invention;
Fig. 2 illustrates a schematic perspective exploded view of the assembled aluminum extrusion heat dissipator of the present invention;
Fig. 3 illustrates a schematic assembled sectional view of the assembled aluminum extrusion heat dissipator of the present invention;
Fig. 4 illustrates another schematic application view of the assembled aluminum extrusion heat dissipator of the present invention;
Fig. 5 illustrates still another schematic application view of the assembled aluminum extrusion heat dissipator of the present invention; and
Fig. 6 illustrates yet another schematic application view of the assembled aluminum extrusion heat dissipator of the present invention.

### DETAILED DESCRIPTION OF THE INVENTION

Following preferred embodiments and figures will be described in detail so as to achieve aforesaid objects.

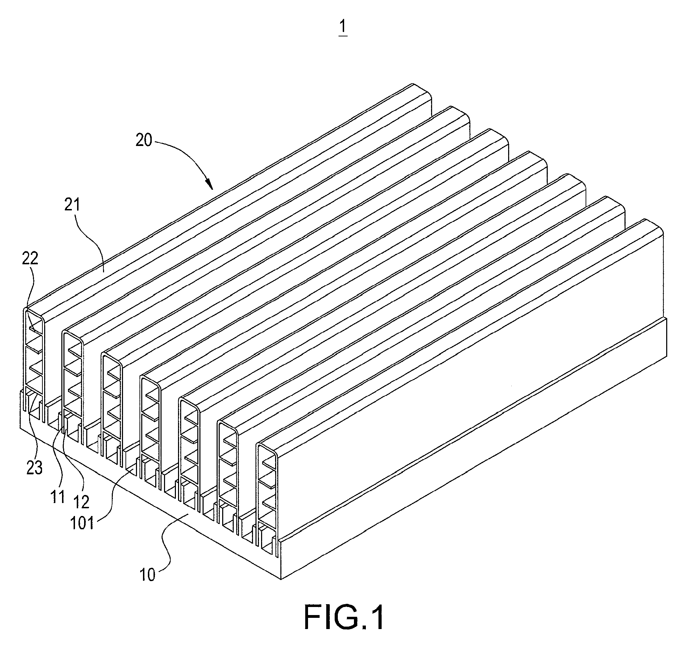

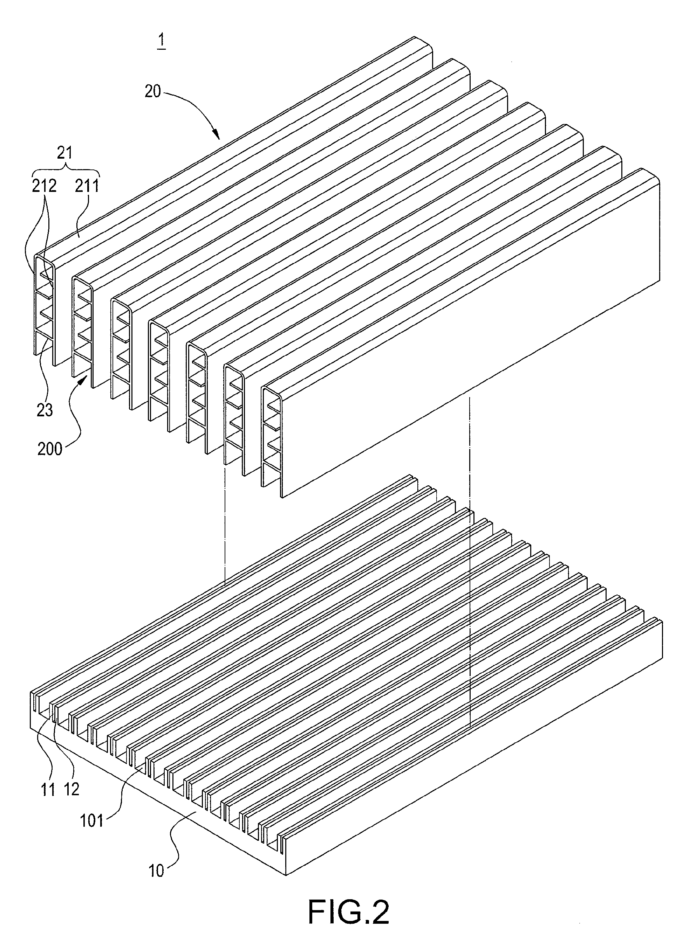

Please refer to Figs. 1-3, which illustrate a schematic perspective view of the assembled aluminum extrusion heat dissipator of the present invention, a schematic perspective exploded view of the assembled aluminum extrusion heat dissipator of the present invention, and a schematic assembled sectional view of the assembled aluminum extrusion heat dissipator of the present invention. The assembled aluminum extrusion heat dissipator 1 of the present invention comprises a heat-conducting plate 10 and at least one U-shaped heat-dissipating member 20. The heat-conducting plate 10 and the U-shaped heat-dissipating member 20 are an aluminum extrusion component respectively. The bottom surface of the heat-conducting plate 10 is adhered to a heating component, the other surface, corresponding to the bottom surface, of the heat-conducting plate 10 is integrated with the at least one U-shaped heat-dissipating member 20.

The heat-conducting plate 10 is made of aluminum with an outstanding thermal conductivity. The surface 101 of the heat-conducting plate 10 has a plurality of slots 11 that are parallel to each other. Each of the slots 11 extends from one side of the heat-conducting plate 10 to another corresponding side. For the preferred embodiment, the distance between every two adjacent slots 11 is equal to the other distance between every other two adjacent slots 11. The slot 11 is constructed by two boards 12 that are spaced, and the boards 12 outwardly extend from the surface 101 of the heat-conducting plate 10. In practice, the extended boards 12 slightly have elastic deformation forces. The bottom of each slot 11 is not lower than the surface 101. The position of the bottom of the slot 11 is not limited thereto, and practically the bottom of the slot 11 can be lower or higher than the surface 101.

The U-shaped heat-dissipating member 20 is made of aluminum with an outstanding thermal conductivity as well. The U-shaped heat-dissipating member 20 has a U-shaped body 21 and a plurality of heat-dissipating fins 22. The U-shaped body 21 has a bottom plate 211 and a pair of lateral plates 212 that bend and extend from the two opposite sides of the bottom plate 211. For the embodiment, a heat-dissipating channel 200 is among the bottom plate 211 and the pair of lateral plates 212 and is though the U-shaped body 21. Besides, the heat-dissipating fins 22 extend from the inner wall of one of the lateral plates 212 to the other lateral plate 212, wherein the distance between the pair of lateral plates 212 is corresponding to the distance of the two adjacent slots 11, so that the pair of lateral plates 212 insert into the two adjacent slots 11, and the U-shaped heat-dissipating member 20 integrates with the heat-conducting plate 10.

For an embodiment of the present invention, the U-shaped heat-dissipating member 20 further comprises a support plate 23, which extends from the inner wall of one of the lateral plates 212 to the inner wall of the other lateral plate 212. Preferably, the support plate 23 is disposed at a position far from the bottom plate 211, in order to support the lateral plates 212 and prevent the deformation of the lateral plates 212 for keeping a certain distance between the two lateral plates 212.

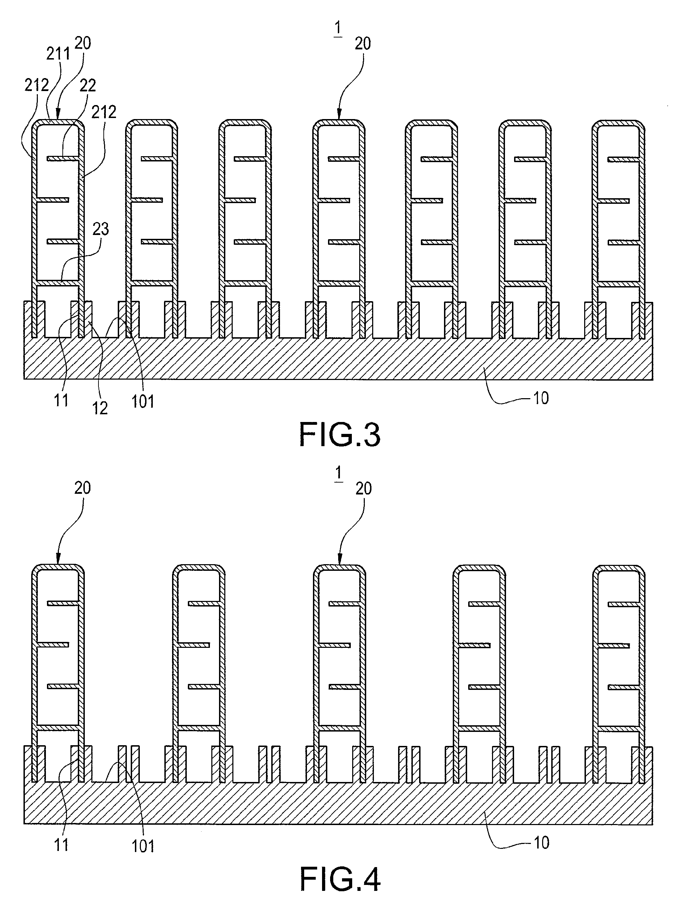

The amount of the U-shaped heat-dissipating member 20 is a plurality, and the two lateral plates 212 of each U-shaped heat-dissipating member 20 insert into the two adjacent slots 11 of the heat-conducting plate 10 so as to assemble the U-shaped heat-dissipating members 20 with the heat-conducting plate 10. Since the slot 11 is formed by the two boards 12 with the elastic deformation forces, the two boards 12 then securely clamp the each lateral plate 212 of the U-shaped heat-dissipating member 20, so the U-shaped heat-dissipating member 20 firmly integrates with the slots 11. For an embodiment of the present invention, as shown in Fig. 3, the heights of the U-shaped heat-dissipating members 20 inserting into the heat-conducting plate 10 are equal to each other. In practice, the arrangement of the U-shaped heat-dissipating members 20 can be altered based on demands.

Please refer to Fig. 4, which illustrates another schematic application view of the assembled aluminum extrusion heat dissipator of the present invention. For the embodiment, the assembly of the heat-conducting plate 10 and the U-shaped heat-dissipating members 20 is mostly similar to aforesaid embodiment. The difference between the present embodiment and aforesaid embodiment is that at least one slot 11 is left between the two adjacent U-shaped heat-dissipating members 20. The arrangement of the present embodiment is to reduce the density of the U-shaped heat-dissipating members 20 on the heat-conducting plate 10. In other words, the gap between every two adjacent U-shaped heat-dissipating members 20 is enlarged.

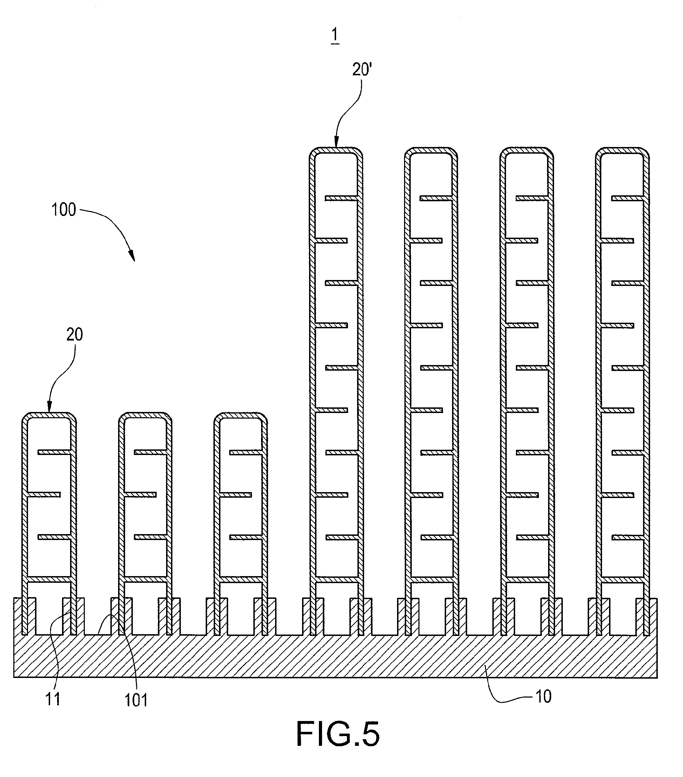

Please refer to Fig. 5, which illustrates still another schematic application view of the assembled aluminum extrusion heat dissipator of the present invention. For the embodiment, the assembly of the heat-conducting plate 10 and the U-shaped heat-dissipating members 20 is mostly similar to aforesaid embodiment. The difference between the present embodiment and aforesaid embodiment is that the heights of the U-shaped heat-dissipating members 20, 20' inserting into the heat-conducting plate 10 are different. For the present embodiment, the U-shaped heat-dissipating members 20, 20' with the same height are arranged as one set, and a height difference 100 is formed between two adjacent sets of the U-shaped heat-dissipating members 20, 20'. The height difference 100 is used to keep away from other components and may be varied based on demands.

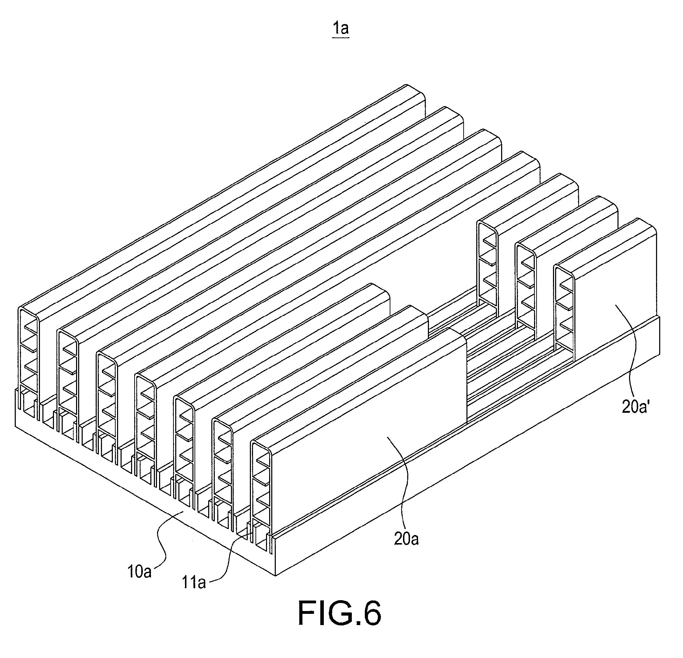

Please refer to Fig. 6, which illustrates yet another schematic application view of the assembled aluminum extrusion heat dissipator of the present invention. For the embodiment, it is mostly similar to aforesaid embodiment. The assembled aluminum extrusion heat dissipator 1a comprises a heat-conducting plate 10a and a plurality of U-shaped heat-dissipating members 20a, 20a'. The heat-conducting plate 10a and the plurality of U-shaped heat-dissipating members 20a, 20a' are aluminum extrusion components. The heat-conducting plate 10a has a plurality of slots 11a that are parallel to each other. The U-shaped heat-dissipating members 20a, 20a' integrate with the slots 11a of the heat-conducting plate 10a. The difference between the present embodiment and aforesaid embodiments is that there are separating two U-shaped heat-dissipating members 20a, 20a' integrated with the slots 11a.

For the present embodiment, two discontinuous U-shaped heat-dissipating members 20a, 20a' are disposed in the two adjacent slots 11a, and the U-shaped heat-dissipating members 20a, 20a' can be different in height or length. Besides, the plurality of the U-shaped heat-dissipating members 20a, 20a' are serially or intermittently arranged. The arrangement is to keep away from other components and may be varied based on demands.

In summary there is disclosed an assembled aluminum extrusion heat dissipator 1, 1a including a heat-conducting plate 10, 10a and a plurality of U-shaped heat-dissipating members 20, 20', 20a, 20a'. The surface 101 of the heat-conducting plate 10, 10a has a plurality of slots 11, 11a, and each of the slots 11, 11a extends from one side of the heat-conducting plate 10, 10a to another corresponding side. The U-shaped heat-dissipating member 20, 20', 20a, 20a' has a U-shaped body 21 and a plurality of heat-dissipating fins 22, and the U-shaped body 21 having a bottom plate 211 and a pair of lateral plates 212, wherein the distance between the pair of lateral plates 212 is corresponding to the distance of the two adjacent slots 11, 11a, so that the pair of lateral plates 212 insert into the two adjacent slots 11, 11a, and the U-shaped heat-dissipating member 20, 20', 20a, 20a' integrates with the heat-conducting plate 10, 10a.

Although the invention has been disclosed and illustrated with reference to particular embodiments, the principles involved are susceptible for use in numerous other embodiments that will be apparent to persons skilled in the art. This invention is, therefore, to be limited only as indicated by the scope of the appended claims.

## Claims

1. An assembled aluminum extrusion heat dissipator (1, 1a), comprising:
a heat-conducting plate (10, 10a), a surface (101) of the heat-conducting plate (10, 10a) having a plurality of slots (11, 11a) that are parallel to each other, each slot (11, 11a) being constructed by two boards (12) that are spaced, the boards (12) outwardly extending from the surface (101) of the heat-conducting plate (10, 10a), each of the slots (11, 11a) extending from one side of the heat-conducting plate (10, 10a) to another corresponding side; and
at least one U-shaped heat-dissipating member (20, 20', 20a, 20a'), having a U-shaped body (21) and a plurality of heat-dissipating fins (22), the U-shaped body (21) having a bottom plate (211) and a pair of lateral plates (212) that bend and extend from two opposite sides of the bottom plate (211), the heat-dissipating fins (22) extending from the inner wall of one of the lateral plates (212) to the other lateral plate (212);
wherein a distance between the pair of lateral plates (212) is corresponding to a distance of the two adjacent slots (11, 11a), so that the pair of lateral plates (212) insert into the two adjacent slots (11, 11a), and the U-shaped heat-dissipating member (20, 20', 20a, 20a') integrates with the heat-conducting plate (10, 10a).

2. The assembled aluminum extrusion heat dissipator according to claim 1, wherein the U-shaped heat-dissipating member (20, 20', 20a, 20a') further comprises a support plate (23), which extends from the inner wall of one of the lateral plates (212) to the inner wall of the other lateral plate (212).

3. The assembled aluminum extrusion heat dissipator according to claim 2, wherein the support plate (23) is disposed at a position far from the bottom plate (211).

4. The assembled aluminum extrusion heat dissipator according to claim 1, wherein a heat-dissipating channel (200) is among the bottom plate (211) and the lateral plates (212) and is though the U-shaped body (21).

5. The assembled aluminum extrusion heat dissipator according to claim 1, wherein a distance between every two adjacent slots (11, 11a) is equal to the other distance between every other two adjacent slots (11, 11a).

6. The assembled aluminum extrusion heat dissipator according to any of claims 1-5, wherein there are a plurality of U-shaped heat-dissipating members (20, 20', 20a, 20a'), the heights of the U-shaped heat-dissipating members (20, 20', 20a, 20a') inserting in the heat-conducting plate (10, 10a) being different.

7. The assembled aluminum extrusion heat dissipator according to 6, wherein the U-shaped heat-dissipating members (20, 20', 20a, 20a') with the same height are arranged as one set, and a height difference (100) is between the two adjacent sets of the U-shaped heat-dissipating members (20, 20', 20a, 20a').

8. The assembled aluminum extrusion heat dissipator according to any of claims 1-5, wherein there are a plurality of U-shaped heat-dissipating members (20, 20', 20a, 20a'), any of the two adjacent slots (11, 11a) being disposed one of the plurality of the U-shaped heat-dissipating members (20, 20', 20a, 20a').

9. The assembled aluminum extrusion heat dissipator according to claim 8, wherein the plurality of the U-shaped heat-dissipating members (20, 20', 20a, 20a') in any of the two adjacent slots (11, 11a) are serially or intermittently arranged.

10. The assembled aluminum extrusion heat dissipator according to claim 9, wherein the plurality of the U-shaped heat-dissipating members (20, 20', 20a, 20a') are different in height or length.
